# EUROPEAN PATENT APPLICATION

(11) **EP 0 859 424 A2**
(43) Date of publication of application: **19.08.1998**
(21) Application number: 98301152.9
(22) Date of filing: 17.02.1998
(51) Int. Cl.: H01P 1/387

(54) **Surface mount technology contact for ferrite isolator/circulator applications**

(30) Priority: 18.02.1997 US 38844 P
(71) Applicant: THE WHITAKER CORPORATION, Wilmington, Delaware 19808 (US)
(72) Inventor: Paquette, Stan, Dracut, MA 01826 (US); Jussaume, Raymond, Somerville, MA 02145 (US)
(74) Representative: Warren, Keith Stanley

(57) **Abstract**

A housing (201) for surface mounting a passive microwave device on an electronic circuit board, comprises rigid lead supports (202), contact receiving holes (203), a conductive bottom surface (204) and a lid. Contact pins (301) overmolded with dielectric material (302) are press fitted into the holes (203) such that, when in place, the bottom surface of each pin (301) is flush with the bottom surface (204) of the housing. In use, the leads of the microwave device pass through openings in the sidewall of the housing (201) and are attached to the pins (301). when surface mounted on the circuit board the bottom surfaces (204) of the housing and the pins (301) make good contact with cooperating contacts on the circuit board.

## Description

The present invention relates to a robust surface mount contact structure and housing for ferrite isolators/circulators for applications in signal transmission lines, particularly, at microwave frequencies.

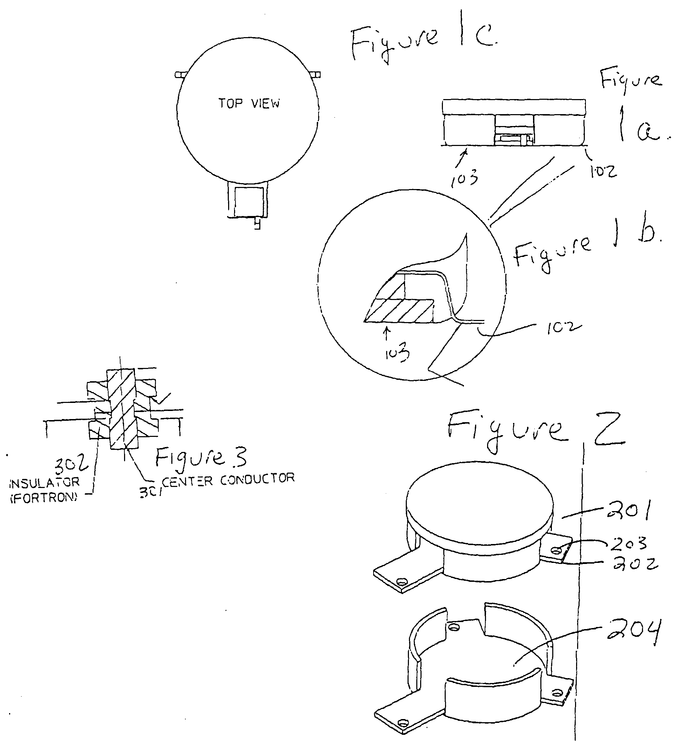

Ferrite Isolators/Circulators have a great deal of applicability in microwave applications. While the design and function of the ferrite isolator/circulator has proven to be reliable and repeatable, the device structure and contacts for connecting the ferrite isolator/circulator to signal transmission lines has proven to have problems from the standpoint of manufacturing and/or ease of installation and subsequent progression into automation. To this end, the conventional structure for a ferrite isolator/circulator is shown in cross section in Figures 1a and 1b. The structure shown in Figure 1a is a typical ferrite housing can with the ferrite isolator/circulator mounted therein having electrical contacts for surface mount application, as shown as 102 in Figures 1a and 1b. The top view of the ferrite can is shown in Figure 1c with the contacts 102 shown for typical applications. Surface mount technology in the microwave industry has wide spread applicability and acceptance. Structures such as shown in Figures 1a - 1c are designed to be adaptable to surface mount technology. The lead assembly shown in Figure 1b has the lead 102 designed to rest in the same plane as the bottom of the can as at 103. The purpose of this is to ensure good electrical connection and also ensure that the main housing base has a good electrical contact with its respective contact surface on the PC Board. Although zero tolerance coplanarity would be ideal, common manufacturing practices allow a certain amount of tolerance of deviation, but more tolerance than would be allowed by typical solder pad thickness deposition from the ferrite to the signal line via 102. Thereafter, the contact 102 is soldered via a solder pad to the signal transmission line disposed on the printed circuit board.

While the design shown in Figures 1a - 1c has met with some success, there are certain drawbacks which have proved problematic with this design. As stated, the industry standard is the use of surface mount technology. Unfortunately, the structure shown in Figures 1a - 1c requires manual placement of the ferrite cans and contacts as opposed to a automated pick and place method of manufacture due to the lack of coplanarity of the contact leads relative to the base of the housing. Accordingly this slows down the process of manufacture and increases the labor intensity and therefore the overall cost. The reason that manual placement is required is to assure that the contacts 102 are properly connected to the signal lines on the printed circuit board and done so in a reliable manner. one of the problems associated with the contacts as shown at 102 are bending during handling and shipping of the device. The structure shown ideally in Figure 1b has the lead 102 in the same plane as the bottom of the can at 103. During shipping and handling, the lead as shown can be bent and therefore not properly positioned. The assembly thereafter requires that the lead be rebent to its proper position. Even after the lead is properly bent and placed, there are reliability issues that require further testing time to assure electrical and mechanical integrity of the final product.

Accordingly, what is needed is a structure for a ferrite isolator/circulator having a more robust and truly surface mount contact assembly which enables fully automated placement and soldering. Such a structure will enable a greater consistency from unit to unit and effect a more standard product.

The present invention relates to a more durable and rugged structure for making the electrical connection between a ferrite isolator/circulator disposed in a housing and a signal transmission line disposed on a printed circuit board. The leads for making a contact between the signal line and the ferrite Isolator/Circulator are much more rigid and truly surface mountable enabling fully automated placement and soldering thereafter. The housing structure for the ferrite Isolator/Circulator is metal with the bottom surface of the housing or can having rigid lead supports extending from the metal housing. The ferrite leads are connected to the signal line and are isolated from the ground connection at the bottom of the can by dielectric material disposed between the lead and the lead support structure. Because of the durable and rigid support for the leads from the ferrite circuit to the signal transmission lines on the printed circuit board, it is possible to produce a lead which is coplanar with the bottom of the can and therefore effects a true surface mount structure. A variety of lead assemblies are anticipated with the present invention. The preferred embodiment utilizes a contact lead which is inserted into a dielectric material and thereafter the lead and dielectric are inserted into a hole in the lead support member of the ferrite housing. The resulting product is a true surface mount technology structure having a robust lead assembly which is readily adaptable to fully automated placement and soldering. The in house processing time of the final product is reduced dramatically due to the more rigid and durable unit and the final product is more consistent from unit to unit.

It is an object of the present invention to have a surface mount technology, ferrite Isolator/Circulator structure which is readily adaptable to automated manufacturing.

It is a further object of the present invention to have a surface mount technology ferrite Isolator/Circulator which is both durable and robust.

It is a feature of the present invention to have a rigid support structure for the electrical leads connecting the ferrite Isolator/Circulator to the signal transmission lines.

It is a further feature of the present invention to have the lead contacts of the ferrite Isolator/Circulator coplanar with the bottom of the housing in a substantially fixed manner.

It is an advantage of the present invention to have a structure which is substantially standard from unit to unit.

In the accompanying drawings:-

FIGURES 1a-1c show a conventional ferrite Isolator/Circulator in a housing member having contact leads.

FIGURE 2 shows a preferred embodiment of the housing or can structure of the present invention.

FIGURE 3 is a cross sectional view of the press fit contact with the dielectric material serving as a insulator between the support leads of the housing and the contact.

FIGURE 4 is an isometric view of the preferred embodiment.

FIGURE 5 is a top view of an alternative structure having a dielectric support member with the leads disposed thereon, the dielectric support member being insertable into a standard can housing.

Turning to Figure 2, the housing member 201 for the ferrite Isolator/Circulator is shown. The housing 201 is fabricated from a metal that allows the conduction of magnetic energy, for example, cold rolled steel and specific grades of stainless steel. The important feature is rigidity. The lead supports for the contacts of the ferrite Isolator/Circulator are shown at 202 and provide support for the Isolator/Circulator leads and connections thereto. Holes are disposed as shown at 203 for supporting the leads as well as the dielectric material which is press fitted therein, thereby isolating the leads from the metal housing 201. The bottom surface of the metal housing 204 provides contact to electrical ground in the Isolator/Circulator structure.

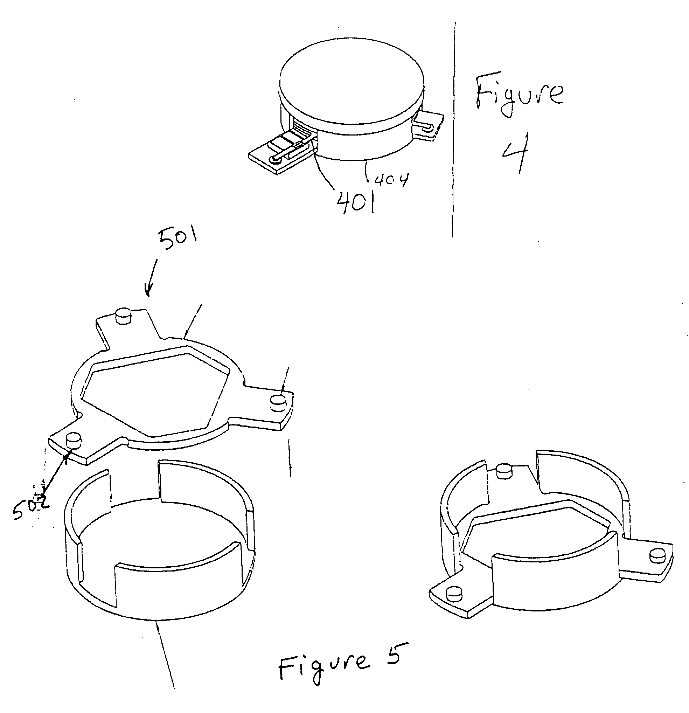

Figure 3 shows the lead contact for surface mount connection between the Isolator/Circulator and the signal transmission lines disposed on the printed circuit board. The lead contact 301, fabricated from beryllium-copper, copper, or any other suitable conductor of electricity, is disposed in a dielectric material 302 which functions as an Isolator/Circulator between the contact 301 and the housing 201. The dielectric material 302 may be overmolded on the contact 301. The preferred embodiment is an under cut in the center of the contact to ensure one piece-like construction. This contact is thereafter disposed into the holes in the lead support member 202 at 203. The final product is as shown in Figure 4. To this end, the lead support member 202 has the dielectric material 302 press fitted into the hole 203 with the contact member 301 as shown. This contact 301, is connected to the lead 401 of the ferrite. The resultant product as shown in Figure 4 has the pin 301 substantially coplanar with the bottom of the housing member 201 as shown in Figure 4, at 404. By virtue of the fact that the lead supports 202 are very rugged in nature,once the coplanar relationship between the bottom of the lead 301 and the bottom of the can 404 is established, it is unnecessary to make any adjustments to assure a proper surface mount on the printed circuit board. This is, of course, one of the true advantages of the present invention in that once the device is mounted to the printed circuit board, a true flush circuit surface mount structure is effected between the electrical ground and member 404 as well as between the respective signal lines (not shown) and the bottom of the contact pins 301.

Turning to Figure 5, an alternative structure is shown to the present invention. This structure has a dielectric support member 501 with a hole therein at 502 for aligning the ferrite material and center conductor for the Isolator/Circulator. The dielectric support member like the other dielectric materials of the present invention requires durability at relatively high temperatures due to the soldering processes that take place during manufacture. A suitable material is, for example, fortron which enables solder reflow at temperatures of greater than 260 degree Celsius. The use of the dielectric insert, as shown in Figure 5, enables a standard can for the housing into which the ferrite is disposed. That is to say, the standard can be used with the ferrite material disposed in the dielectric support and the dielectric support thereafter mounted appropriately in the can as necessary for various applications.

Additionally, it is possible to have a variety of structures for the housing member as well as for the contact members. To this end, it is also possible to have a slot as opposed to a hole in the lead support members, as shown at 203 in Figure 2, these slotted lead support members may be necessary to avoid solder joint breakage or to aid in assembly. In some instances, thermal expansion tendencies of components used in the circulator unit require that some movement be allowed of the contact pin relative to the support structure of the unit. A slot will serve this purpose in that the contact assembly is allowed to move in a direction that would be induced by thermal expansion of the various components. Possible variances of thermal expansion coefficients and a designed amount of thermal expansion rates therefore requires free distances. In some cases, also, a slot may be useful in that it is perpendicular to the height requiring coplanarity radial to the unit center, although other directions of assembly of the contact pin in the housing may be acceptable.

Having described the invention in detail it is clear that many variations and modifications may be made to the above disclosure, such modifications being readily apparent to one of ordinary skill in the art. To the extent that such variations and modifications of the present disclosure of a rugged structure for a ferrite Isolator/Circulator having contact members which are supported by rugged lead support members and result in a product which is substantially surface mount in nature requiring very little adjustment during manufacture, such are deemed within the scope of the present invention.

## Claims

1. A structure for a passive microwave device, comprising a housing (201) with openings for electrical leads, characterized by substantially rigid contact supports (202) extending adjacent the openings, electrical contacts disposed in openings (203) in the supports, and dielectric material (302) disposed about said contacts, said contacts and a bottom surface of said housing being substantially flush.

2. A structure as claimed in claim 1, wherein the contact supports comprise the dielectric material (501).

3. A structure as claimed in claim 2, wherein a unitary piece (501) of dielectric material is placed in the housing and the contact supports comprise sections of the dielectric material protruding from selective openings of the housing.

4. A structure as claimed in claim 2 or 3, wherein the housing is metal.

5. A structure as claimed in claim 1, 2, 3 or 4, wherein the device is an isolator.

6. A structure as claimed in claim 1, 2, 3 or 4, wherein the device is a circulator.

7. A structure for a passive microwave device comprising a housing (201) with circumferential sides and openings in said sides for accommodating electrical contacts (301) for the passive device, characterized in that substantially rigid lead supports (202) for providing structural supports for the contacts (301) protrude adjacent the openings.

8. A structure as claimed in claim 7, wherein the contacts (301) are substantially cylindrical in cross section and have a dielectric material (302) disposed thereabout, said contacts being exposed at bottom surfaces thereof.

9. A structure as claimed in claim 8, wherein the housing (201) has a bottom surface (103) for effecting electrical ground, and said bottom surfaces of said contacts (301) are substantially flush with said bottom surface of said housing.
